# EUROPÄISCHE PATENTANMELDUNG

(11) **EP 2 442 035 A2**
(43) Veröffentlichungstag der Anmeldung: **18.04.2012**
(21) Anmeldenummer: 11008046.2
(22) Anmeldetag: 05.10.2011
(51) Int. Cl.: F24C 7/08, A47L 15/42

(54) **Bedienvorrichtung für ein elektrisches Haushaltsgerät**

(30) Priorität: 12.10.2010 DE 102010048237
(71) Anmelder: Diehl AKO Stiftung & Co. KG, 88239 Wangen (DE)
(72) Erfinder: Heimann, Uwe, 88239 Wangen (DE); Prinz, Michael, 88299 Leutkirch (DE)
(74) Vertreter: Diehl Patentabteilung

(57) **Zusammenfassung**

Eine Bedienvorrichtung für ein elektrisches Haushaltsgerät umfasst eine Bedienblende (10), die auf der einem Benutzer zugewandten Seite der Bedienvorrichtung angeordnet ist und wenigstens ein Bedienfeld (12) definiert; und eine Funktionsbaugruppe (16), die auf der dem Benutzer abgewandten Seite der Bedienblende (10) angeordnet ist und wenigstens einen berührungs- und/oder annäherungsempfindlichen Tastschalter (21) aufweist, wobei der wenigstens eine Tastschalter (21) der Funktionsbaugruppe (16) dem wenigstens einen Bedienfeld (12) der Bedienblende (10) korrespondierend positioniert ist. Ferner ist eine Verbindungsvorrichtung (32) vorgesehen, welche unlösbar mit der Bedienblende (10) verbunden ist, wobei die Funktionsbaugruppe (16) derart lösbar an der Verbindungsvorrichtung (32) befestigt ist, dass sie lösbar und spielfrei mit der Bedienblende (10) verbunden ist.

## Beschreibung

Die vorliegende Erfindung betrifft eine Bedienvorrichtung für ein elektrisches Haushaltsgerät nach dem Oberbegriff des Anspruches 1.

Bedienvorrichtungen für elektrische Haushaltsgeräte wie Kochfelder, Herde, Mikrowellenöfen, Spülmaschinen, Waschmaschinen, Wäschetrockner, Waschtrockner und dergleichen werden immer häufiger mit berührungs- und/oder annäherungsempfindlichen Tastschaltern ausgestattet. Für derartige Tastschalter sind insbesondere die folgenden Technologien bekannt: kapazitive Sensoren, induktive Sensoren, piezoelektrische Sensoren und Sensoren mit Dehnungsmessstreifen.

Die für die Tastschalter anzuwendende Technologie wird u.a. in Abhängigkeit von der Beschaffenheit der Bedienblende der Bedienvorrichtung ausgewählt. Bei elektrisch nicht leitenden Bedienblenden z.B. aus Kunststoff, Glas oder Glaskeramik gilt der kapazitive Sensor in vielen Fällen als einfache und kostengünstige Lösung.

Bei elektrisch leitenden Bedienblenden beispielsweise aus Metall (z.B. Edelstahl) sind alle vier genannten Technologien anwendbar. In diesem Fall wird jede dieser Technologien als druckempfindlich bezeichnet, da sie für eine Tastenbetätigung einen kleinen Bewegungshub - lokalisiert auf den Tastenbereich bzw. das Bedienfeld - auf der Bedienblende erfordert. Dieser Bewegungshub führt bei induktiven und kapazitiven Sensoren zu einer unmittelbaren Änderung des elektrischen Sensorsignals, welche von einer Auswerteelektronik erkannt wird. Bei piezoelektrischen und auf Dehnungsmessstreifen basierenden Sensoren wird über einen solchen Bewegungshub eine Kraft auf das Sensorelement ausgeübt. Diese Krafteinwirkung wird vom jeweiligen Sensorelement erfasst, in ein elektrisches Sensorsignal umgewandelt und von der Auswerteelektronik zwecks Tastenbetätigungserkennung ausgewertet.

Die exakte Erfassung derartiger kleiner Bewegungshübe erfordert eine sehr kompakte und starre Verbundweise für die gesamte Bedienvorrichtung, verbunden mit einer - nur auf die jeweiligen individuellen Bedienfelder beschränkten - relativ hohen lokalen Elastizität. Herkömmlicherweise wird diese Aufgabe dadurch gelöst, dass ein mehrschichtiger Verbundaufbau gewählt wird, bei dem die Bedienblende, die zum Beispiel als Sensorfolie ausgebildeten berührungsempfindlichen Tastschalter und eine Stützplatte mittels Klebeschichten unlösbar und möglichst steif miteinander verbunden werden. Dabei wird natürlich die Verklebung im Bereich der Tastschalter ausgespart. Auf diese Weise entsteht ein stabiler Verbund aus einer Bedienblende und einer Funktionsbaugruppe, der als eine Baueinheit in ein elektrisches Haushaltsgerät eingebaut werden kann. Nachteilig bei einer derartigen Verbundkonstruktion sind die aufwändigen Klebeprozesse sowie das Erfordernis des Austausches der gesamten Bedienvorrichtung einschließlich Bedienblende und Funktionsbaugruppe im Reparaturfall.

Es ist die Aufgabe der vorliegenden Erfindung, eine Bedienvorrichtung für ein elektrisches Haushaltsgerät mit berührungs- und/oder annäherungsempfindlichen Tastschaltern vorzusehen, welche einfach und zugleich funktionssicher aufgebaut ist.

Diese Aufgabe wird gelöst durch eine Bedienvorrichtung für ein elektrisches Haushaltsgerät mit den Merkmalen des Anspruchs 1 oder des Anspruches 2. Vorteilhafte Ausgestaltungen und Weiterbildungen der Erfindung sind Gegenstand der abhängigen Ansprüche.

Gemäß einem ersten Aspekt der Erfindung umfasst die Bedienvorrichtung für ein elektrisches Haushaltsgerät eine Bedienblende, die auf der einem Benutzer zugewandten Seite der Bedienvorrichtung angeordnet ist und wenigstens ein Bedienfeld definiert; und eine Funktionsbaugruppe, die auf der dem Benutzer abgewandten Seite der Bedienblende angeordnet ist und wenigstens einen berührungs- und/oder annäherungsempfindlichen Tastschalter aufweist, wobei der wenigstens eine Tastschalter der Funktionsbaugruppe dem wenigstens einen Bedienfeld der Bedienblende korrespondierend positioniert ist, und ist erfindungsgemäß dadurch gekennzeichnet, dass eine Verbindungsvorrichtung vorgesehen ist, welche unlösbar mit der Bedienblende verbunden ist; und die Funktionsbaugruppe derart lösbar an der Verbindungsvorrichtung befestigt ist, dass sie lösbar und spielfrei mit der Bedienblende verbunden ist.

Anstelle eines unlösbaren Gesamtverbundes aus Bedienblende und Funktionsbaugruppe schlägt die Erfindung vor, die Komponenten Bedienblende und Funktionsbaugruppe lösbar miteinander zu verbinden. Zu diesem Zweck ist eine Verbindungsvorrichtung zwischengeschaltet, welche einerseits unlösbar mit der Bedienblende verbunden ist und andererseits eine lösbare Befestigung der Funktionsbaugruppe erlaubt.

Während die Bedienvorrichtung weiterhin als einheitliche Baugruppe in einem elektrischen Haushaltsgerät montiert werden kann, wird ihre Herstellung selbst vereinfacht, da weniger aufwändige Klebeverbindungen ausgeführt werden müssen. Zudem muss in einem Reparaturfäll nicht die komplette Bedienvorrichtung ausgetauscht werden, sondern es genügt der Austausch der jeweils defekten Komponente von Bedienblende und Funktionsbaugruppe.

Die erfindungsgemäße Konstruktion ist insbesondere im Fall von . Bedienvorrichtungen mit elektrisch leitenden Bedienblenden von Vorteil, bei denen ein kompakter und starrer Aufbau der Bedienvorrichtung zum zuverlässigen Erfassen eines Bewegungshubes notwendig ist. Aus diesem Grund muss die Verbindungsvorrichtung derart konzipiert sein, dass sie eine lösbare, aber zugleich spielfreie Verbindung zwischen der Funktionsbaugruppe und der Bedienblende gewährleistet. Diese Eigenschaft sollte möglichst auf für den Fall von Fertigungstoleranzen, Temperaturgängen und Alterungseinflüssen gelten.

Die erfindungsgemäße Bedienvorrichtung ist in elektrischen Haushaltsgeräten wie beispielsweise Kochfeldern, Herden, Mikrowellenöfen, Spülmaschinen, Waschmaschinen, Wäschetrockner, Waschtrocknern und dergleichen in vorteilhafter Weise einsetzbar.

Die "berührungs- und/oder annäherungsempfindlichen Tastschalter" enthalten üblicherweise kapazitive Sensoren, induktive Sensoren, piezoelektrische Sensoren und auf Dehnungsmessstreifen basierende Sensoren. Die Erfindung soll aber nicht auf diese Ausführungsformen von Tastschaltern beschränkt sein; so können beispielsweise auch optische Sensoren zum Einsatz kommen.

Die "unlösbare Verbindung" zwischen der Verbindungsvorrichtung und der Bedienblende wird beispielsweise durch eine Klebe- oder Lötverbindung erzielt. Außerdem besteht die Möglichkeit, die Verbindungsvorrichtung einstückig mit der Bedienblende auszubilden.

Unter eine "lösbaren Verbindung" zwischen der Funktionsbaugruppe und der Bedienblende sollen Verbindungen verstanden werden, die mit oder ohne Werkzeug im Wesentlichen zerstörungsfrei wieder gelöst werden können.

Gemäß einem zweiten Aspekt der Erfindung kann die oben genannte Aufgabe auch durch eine Bedienvorrichtung für ein elektrisches Haushaltsgerät gelöst werden, die eine Bedienblende, die auf der einem Benutzer zugewandten Seite der Bedienvorrichtung angeordnet ist und wenigstens ein Bedienfeld definiert; und eine Funktionsbaugruppe, die auf der dem Benutzer abgewandten Seite der Bedienblende angeordnet ist und wenigstens einen berührungs- und/oder annäherungsempfindlichen Tastschalter aufweist, wobei der wenigstens eine Tastschalter der Funktionsbaugruppe dem wenigstens einen Bedienfeld der Bedienblende korrespondierend positioniert ist, umfasst und dadurch gekennzeichnet ist, dass eine Verbindungsvorrichtung vorgesehen ist, welche unlösbar mit der Funktionsbaugruppe verbunden ist; und dass die Bedienblende derart lösbar an der Verbindungsvorrichtung befestigt ist, dass sie lösbar und spielfrei mit der Funktionsbaugruppe verbunden ist.

Auch bei dieser Konstruktion wird anstelle eines unlösbaren Gesamtverbundes aus Bedienblende und Funktionsbaugruppe eine lösbare Verbindung zwischen den Komponenten Bedienblende und Funktionsbaugruppe vorgeschlagen. Zu diesem Zweck ist wiederum eine Verbindungsvorrichtung zwischengeschaltet, welche hier einerseits unlösbar mit der Funktionsbaugruppe verbunden ist und andererseits eine lösbare Befestigung der Bedienblende erlaubt.

Mit anderen Worten stellt der zweite Lösungsvorschlag gemäß Anspruch 2 eine Umkehr des ersten Lösungsvorschlages gemäß Anspruch 1 im Hinblick auf die Realisierung der zweistufigen, insgesamt lösbaren Verbindung zwischen der Bedienblende und der Funktionsbaugruppe unter Zwischenschaltung der Verbindungsvorrichtung dar. Die obigen Anmerkungen zum ersten Erfindungsaspekt gelten deshalb natürlich in entsprechender Weise auch für diesen zweiten Erfindungsaspekt.

In einer Ausgestaltung der Erfindung weist die Verbindungsvorrichtung eine Vielzahl von Befestigungselementen zum lösbaren Befestigen der Funktionsbaugruppe bzw. der Bedienblende an der Verbindungsvorrichtung auf. Durch das Vorsehen einer Vielzahl von Befestigungselementen kann eine gleichmäßige Kraftverteilung der Befestigung erzielt werden, was wiederum zum Erreichen einer spielfreien Verbindung zwischen der Funktionsbaugruppe und der Bedienblende von Vorteil ist.

Die lösbare Verbindung der Funktionsbaugruppe mit der Bedienblende ist beispielsweise ausgewählt aus Rastverbindungen, Schnappverbindungen, Klemmverbindungen, Schränkverbindungen, Schraubverbindungen und Kombinationen dieser Verbindungsarten.

In einer weiteren Ausgestaltung der Erfindung ist die Funktionsbaugruppe durch die Verbindungsvorrichtung gegen die Bedienblende elastisch vorgespannt. Auf diese Weise kann eine spielfreie Verbindung zwischen der Funktionsbaugruppe und der Bedienblende auch im Fall von Fertigungstoleranzen, Temperatureinflüssen und Alterungserscheinungen noch besser gewährleistet werden.

Der wenigstens eine Tastschalter kann zum Beispiel in Form einer Sensorfolie oder dergleichen ausgeführt sein. Bei dieser Ausgestaltung können auch mehrere Tastschalter in Form einer gemeinsamen Sensorfolie konzipiert sein. Diese Ausgestaltungen ermöglichen einen sehr kompakten Aufbau der Funktionsbaugruppe und damit der gesamten Bedienvorrichtung.

In einer Ausgestaltung der Erfindung weist die Funktionsbaugruppe ferner einen Träger für den wenigstens einen Tastschalter auf. Die Verwendung eines solchen Trägers kann die Stabilität der Funktionsbaugruppe erhöhen und damit ebenfalls einen Beitrag zur spielfreien Verbindung zwischen der Funktionsbaugruppe und der Bedienblende leisten.

Bei der letztgenannten Ausführungsform ist vorzugsweise dieser Träger der Funktionsbaugruppe lösbar an der Verbindungsvorrichtung befestigt (im Fall des ersten Erfindungsaspekts) bzw. dient der unlösbaren Verbindung mit der Verbindungsvorrichtung (im Fall des zweiten Erfindungsaspekts).

In einer weiteren Ausgestaltung der Erfindung kann die Funktionsbaugruppe ferner wenigstens ein Anzeigeelement aufweisen. In diesem Fall kann die Bedienblende ferner wenigstens ein lichtdurchlässiges Anzeigefeld aufweisen, welches dem wenigstens einen Anzeigeelement der Funktionsbaugruppe korrespondierend positioniert ist, und kann die Funktionsbaugruppe ferner wenigstens ein Lichtleitelement aufweisen, das zwischen dem wenigstens einen Anzeigeelement der Funktionsbaugruppe und dem wenigstens einen Anzeigefeld der Bedienblende angeordnet ist.

Obige sowie weitere Merkmale, Vorteile und Anwendungsmöglichkeiten der Erfindung werden aus der nachfolgenden Beschreibung bevorzugter, nichteinschränkender Ausführungsbeispiele unter Bezugnahme auf die beiliegenden Zeichnungen besser verständlich. Darin zeigen teils schematisch:
- Fig. 1: eine Perspektivansicht (teils aufgeschnitten) aus Sicht des Benutzers einer bevorzugten Ausführungsform einer Bedienvorrichtung der Erfindung;
- Fig. 2: eine perspektivische Explosionsansicht der beiden lösbar zur verbindenden Baugruppen gemäß einem bevorzugten Ausführungsbeispiel einer Bedienvorrichtung der Erfindung;
- Fig. 3: eine perspektivische Explosionsansicht der die Bedienblende und die Verbindungsvorrichtung umfassenden Baugruppe der Bedienvorrichtung von Fig. 2;
- Fig. 4: eine perspektivische Ansicht der zusammengesetzten Baugruppe von Fig. 3 aus Richtung der dem Benutzer abgewandten Seite;
- Fig. 5: eine perspektivische Explosionsansicht der Funktionsbaugruppe der Bedienvorrichtung von Fig. 2; und
- Fig. 6: eine perspektivische Ansicht der zusammengesetzten Bedienvorrichtung von Fig. 2 aus Richtung der dem Benutzer abgewandten Seite.

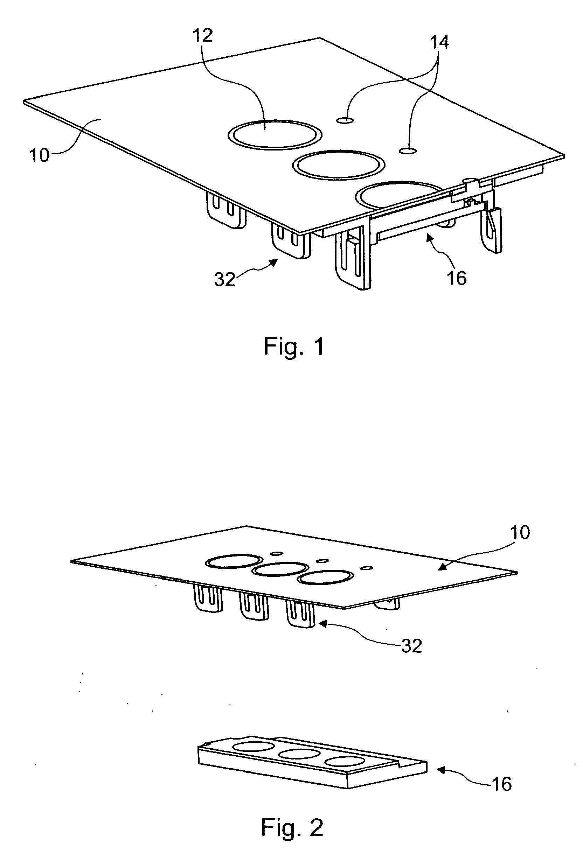

Anhand der Figuren 1 bis 6 wird ein bevorzugtes Ausführungsbeispiel der Bedienvorrichtung beschrieben, welches dem ersten Erfindungsaspekt gemäß Anspruch 1 entspricht. Der Fachmann wird auf dieser Grundlage problemlos eine Ausführungsform für eine Bedienvorrichtung gemäß dem zweiten Erfindungsaspekt gemäß Anspruch 2 erkennen können.

Die Bedienvorrichtung umfasst eine Bedienblende 10 aus einem elektrisch nicht leitenden Material (z.B. Kunststoff, Glas, Glaskeramik) oder einem elektrisch leitenden Material (z.B. Metall wie Edelstahl). In dieser Bedienblende 10 sind mehrere Bedienfelder 12 für den Benutzer gekennzeichnet (z.B. optisch und/oder haptisch). Neben diesen Bedienfeldern 12 sind optional auch mehrere lichtdurchlässige Anzeigefelder 14 vorgesehen, welche in Form von Durchbrüchen oder aus einem transparenten Material gebildet sein können. Die Bedienblende 10 besitzt - bis ggf. auf die lichtdurchlässigen Anzeigefelder 14 - eine im Wesentlichen geschlossene Fläche. D.h. auch die Bedienfelder 12 besitzen jeweils eine im Wesentlichen geschlossene Fläche.

Auf der dem Benutzer abgewandten Seite der Bedienblende ist eine Funktionsbaugruppe 16 angeordnet. Wie weiter unten in mehr Einzelheiten erläutert, enthält diese Funktionsbaugruppe 16 mehrere berührungs- und/oder annäherungsempfindliche Tastschalter 21 und optional mehrere Anzeigeelemente 26, welche in Anzahl und Positionierung den Bedienfeldern 12 bzw. Anzeigefeldern 14 der Bedienblende 10 entsprechen.

Diese Funktionsbaugruppe 16 bildet im Fertigungsprozess eine eigene Baugruppe, welche lösbar mit der Bedienblende 10 verbunden wird. Zu diesem Zweck ist eine Verbindungsvorrichtung 32 vorgesehen, welche zwischen der Bedienblende 10 und der Funktionsbaugruppe 16 angeordnet ist. Diese Verbindungsvorrichtung 32 wird zum Beispiel in Klebetechnik unlösbar mit der dem Benutzer abgewandten Seite der Bedienblende 10 verbunden und bildet damit im Fertigungsprozess ebenfalls eine eigene Baugruppe.

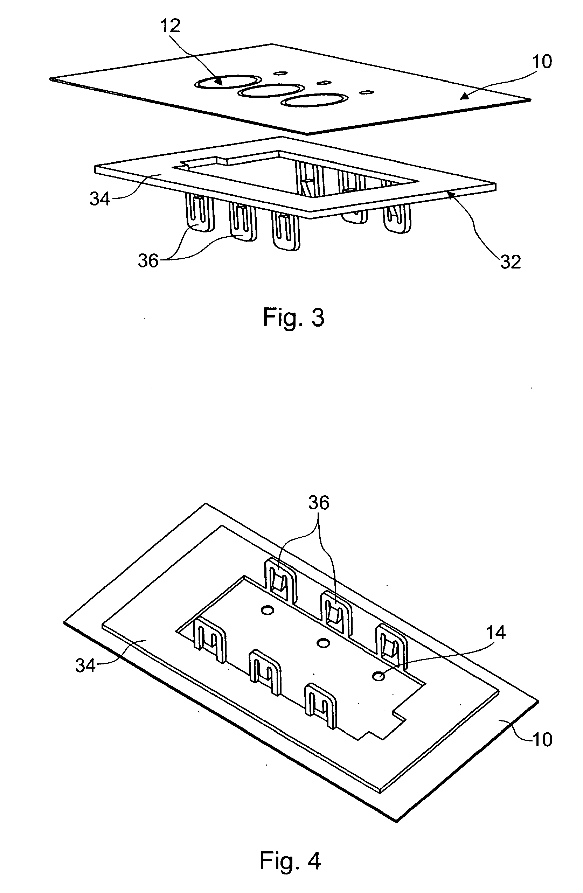

Wie insbesondere in Fig. 3 und 4 zu erkennen ist, ist diese Verbindungsvorrichtung 32 beispielhaft aus einem flachen Rahmen 34 aufgebaut, der mit der Bedienblende 10 verklebt wird. Von diesem Rahmen 34 ragen mehrere Befestigungselemente 36 in Richtung zur Funktionsbaugruppe 16. In diesem Ausführungsbeispiel sind diese Befestigungselemente 36 zur lösbaren Befestigung der Funktionsbaugruppe 16 in der Art einer Rast- bzw. Schnappverbindung ausgebildet.

Die im Fertigungsprozess zusammengefügte Einheit aus Bedienblende 10 und Funktionsbaugruppe 16 kann dann als eine Baukomponente in ein elektrisches Haushaltsgerät eingebaut werden.

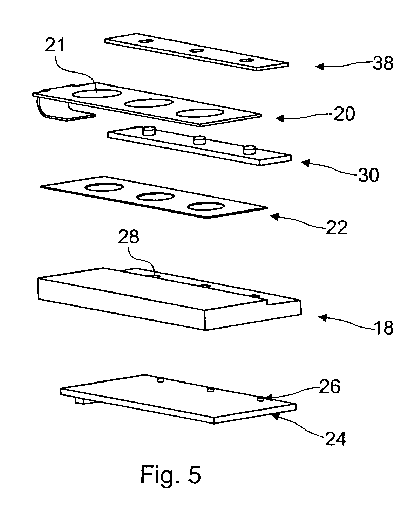

Die Funktionsbaugruppe 16 enthält, wie in Fig. 5 dargestellt, einen Träger 18 zur Eigenstabilisierung der Funktionsbaugruppe 16. Auf der der Bedienblende 10 zugewandten Seite des Trägers 18 wird mittels einer Klebefolie 22 eine Sensorfolie 20 mit mehreren Tastschaltern 21 aufgebracht. Diese Tastschalter 21 sind als berührungs- und/oder annäherungsempfindliche Tastschalter ausgebildet und enthalten beispielsweise kapazitive Sensoren, induktive Sensoren, piezoelektrische Sensoren oder Sensoren mit Dehnungsmessstreifen.

Auf der der Bedienblende 10 abgewandten Seite des Trägers 18 ist eine Leiterplatte 24 angeordnet, welche mit der Sensorfolie 20 bzw. deren Tastschaltern 21 verbunden ist. Die Leiterplatte 24 kann wahlweise nur der weiteren Verbindung der Sensorfolie 20 mit einer Auswerteelektronik dienen oder selbst die Auswerteelektronik für die Tastschalter 21 enthalten. Ferner besteht auch die Möglichkeit, dass die Leiterplatte 18 sowohl die Auswerteelektronik für die Tastschalter 21 als auch zumindest teilweise die Steuerelektronik für das elektrische Haushaltsgerät enthält.

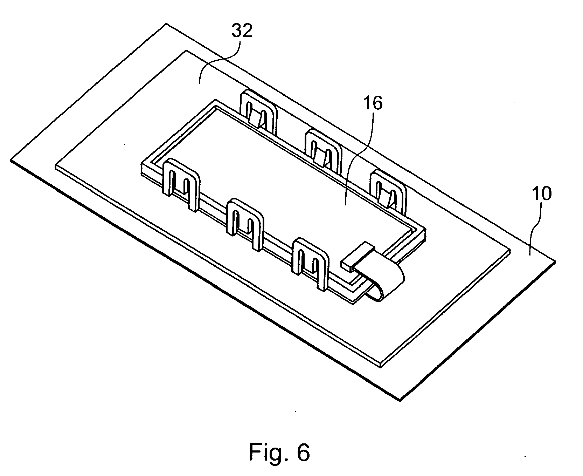

Wie in Fig. 1 und 6 zu sehen, hintergreifen die Befestigungselemente 36 der Verbindungsvorrichtung 32 den Träger 18 bzw. die Leiterplatte 24 der Funktionsbaugruppe 16, sodass die Funktionsbaugruppe 16 und insbesondere deren Tastschalter 21 lösbar und zugleich spielfrei mit der Bedienblende 10 verbunden sind.

Die Verbindungsvorrichtung 32 ist dabei so konzipiert, dass Fertigungstoleranzen, Temperaturgänge, Alterungseinflüsse und dergleichen kompensiert werden und eine völlige Spielfreiheit gewährleistet ist. Die Funktionsbaugruppe 16 besitzt insgesamt eine hohe mechanische Steifigkeit und gleichzeitig eine lokale Nachgiebigkeit im Bereich der Tastschalter; die gesamte Bedienvorrichtung hat ebenfalls eine hohe mechanische Steifigkeit mit einer partiellen lokalen Nachgiebigkeit im Bereich der Bedienfelder 12 bzw. Tastschalter 21.

Außerdem ist die Verbindungsvorrichtung 32 so ausgeführt, dass der bei einer Tastenbetätigung erfolgte minimale Bewegungshub im Bedienfeld 12 der Bedienblende 10 von dem Tastschalter 21 als Betätigungssignal erkannt wird. Im Fall eines kapazitiven oder induktiven Tastschalters 21 wird ein solcher Bewegungshub vom Tastschalter 21 direkt erkannt; bei piezoelektrischen oder auf Dehnungsmessstreifen basierenden Tastschaltern wird über den Bewegungshub eine Kraft auf den Tastschalter 21 ausgeübt und ruft diese Krafteinwirkung beim Tastschalter 21 eine Signalgebung hervor.

Wie erwähnt, kann die Bedienblende 10 neben den Bedienfeldern 12 optional mit lichtdurchlässigen Anzeigefeldern 14 versehen sein. In diesem Fall enthält die Funktionsbaugruppe 16 ebenfalls optional mehrere Anzeigeelemente zum Beispiel in Form von Leuchtdioden 26 oder Displays.

Wie in Fig. 5 veranschaulicht, sind diese Leuchtdioden 26 auf der Leiterplatte 24 der Funktionsbaugruppe 16 angeordnet und ist der Träger 18 mit entsprechenden Durchbrüchen 28 versehen. Zur Reduzierung der Strählungsverluste ist zwischen den Leuchtdioden 26 und den Anzeigefeldern 14 der Bedienblende 10 optional zudem ein Lichtleitelement 30 vorgesehen, welches beispielsweise mittels einer weiteren Klebefolie 38 mit der Rückseite der Bedienblende 10 verklebt werden kann.

### BEZUGSZIFFERNLISTE

- 10: Bedienblende
- 12: Bedienfeld
- 14: lichtdurchlässiges Anzeigefeld
- 16: Funktionsbaugruppe
- 18: Träger
- 20: Sensorfolie
- 21: Tastschalter
- 22: Klebefolie
- 24: Leiterplatte
- 26: Leuchtdioden
- 28: Durchbrüche
- 30: Lichtleitelement
- 32: Verbindungsvorrichtung
- 34: Rahmen
- 36: Befestigungselemente
- 38: Klebefolie

## Patentansprüche

1. Bedienvorrichtung für ein elektrisches Haushaltsgerät, mit
einer Bedienblende (10), die auf der einem Benutzer zugewandten Seite der Bedienvorrichtung angeordnet ist und wenigstens ein Bedienfeld (12) definiert; und
einer Funktionsbaugruppe (16), die auf der dem Benutzer abgewandten Seite der Bedienblende (10) angeordnet ist und wenigstens einen berührungs- und/oder annäherungsempfindlichen Tastschalter (21) aufweist, wobei der wenigstens eine Tastschalter (21) der Funktionsbaugruppe (16) dem wenigstens einen Bedienfeld (12) der Bedienblende (10) korrespondierend positioniert ist,
**dadurch gekennzeichnet, dass**
eine Verbindungsvorrichtung (32) vorgesehen ist, welche unlösbar mit der Bedienblende (10) verbunden ist; und
die Funktionsbaugruppe (16) derart lösbar an der Verbindungsvorrichtung (32) befestigt ist, dass sie lösbar und spielfrei mit der Bedienblende (10) verbunden ist.

2. Bedienvorrichtung für ein elektrisches Haushaltsgerät, mit
einer Bedienblende (10), die auf der einem Benutzer zugewandten Seite der Bedienvorrichtung angeordnet ist und wenigstens ein Bedienfeld (12) definiert; und
einer Funktionsbaugruppe (16), die auf der dem Benutzer abgewandten Seite der Bedienblende (10) angeordnet ist und wenigstens einen berührungs- und/oder annäherungsempfindlichen Tastschalter (21) aufweist, wobei der wenigstens eine Tastschalter (21) der Funktionsbaugruppe (16) dem wenigstens einen Bedienfeld (12) der Bedienblende (10) korrespondierend positioniert ist,
**dadurch gekennzeichnet, dass**
eine Verbindungsvorrichtung vorgesehen ist, welche unlösbar mit der Funktionsbaugruppe (16) verbunden ist; und
die Bedienblende (10) derart lösbar an der Verbindungsvorrichtung befestigt ist, dass sie lösbar und spielfrei mit der Funktionsbaugruppe (16) verbunden ist.

3. Bedienvorrichtung nach Anspruch 1 oder 2,
**dadurch gekennzeichnet, dass**
die Verbindungsvorrichtung (32) eine Vielzahl von Befestigungselementen (36) zum lösbaren Befestigen der Funktionsbaugruppe (16) bzw. der Bedienblende (10) an der Verbindungsvorrichtung (32) aufweist.

4. Bedienvorrichtung nach einem der vorhergehenden Ansprüche,
**dadurch gekennzeichnet, dass**
die lösbare Verbindung der Funktionsbaugruppe (16) mit der Bedienblende (10) ausgewählt ist aus Rastverbindungen, Schnappverbindungen, Klemmverbindungen, Schränkverbindungen, Schraubverbindungen und Kombinationen dieser Verbindungsarten.

5. Bedienvorrichtung nach einem der vorhergehenden Ansprüche,
**dadurch gekennzeichnet, dass**
die Funktionsbaugruppe (16) durch die Verbindungsvorrichtung (32) gegen die Bedienblende.(10) elastisch vorgespannt ist.

6. Bedienvorrichtung nach einem der vorhergehenden Ansprüche,
**dadurch gekennzeichnet, dass**
der wenigstens eine Tastschalter (21) in Form einer Sensorfolie (20) oder dergleichen ausgeführt ist.

7. Bedienvorrichtung nach einem der vorhergehenden Ansprüche,
**dadurch gekennzeichnet, dass**
die Funktionsbaugruppe (16) einen Träger (18) für den wenigstens einen Tastschalter (21) aufweist.

8. Bedienvorrichtung nach einem der vorhergehenden Ansprüche,
**dadurch gekennzeichnet, dass**
die Funktionsbaugruppe (16) ferner wenigstens ein Anzeigeelement (26) aufweist.

9. Bedienvorrichtung nach Anspruch 8,
**dadurch gekennzeichnet, dass**
die Bedienblende (10) wenigstens ein lichtdurchlässiges Anzeigefeld (14) aufweist, welches dem wenigstens einen Anzeigeelement (26) der Funktionsbaugruppe (16) korrespondierend positioniert ist.

10. Bedienvorrichtung nach Anspruch 9,
**dadurch gekennzeichnet, dass**
die Funktionsbaugruppe (16) ferner wenigstens ein Lichtleitelement (30) aufweist, das zwischen dem wenigstens einen Anzeigeelement (26) der Funktionsbaugruppe (16) und dem wenigstens einen Anzeigefeld (14) der Bedienblende (10) angeordnet ist.
